# FASCICULE DE BREVET EUROPEEN

(11) **EP 3 462 187 B1**
(45) Date de publication et mention de la délivrance du brevet: **18.12.2019**
(21) Numéro de dépôt: 18181975.6
(22) Date de dépôt: 05.07.2018
(51) Int. Cl.: G01R 19/155, G01R 25/00, G01R 19/25

(54) **SYSTÈME INDICATEUR DE PRÉSENCE TENSION DANS UN RÉSEAU HAUTE TENSION**
SPANNUNGSPRÄSENZ-ANZEIGESYSTEM IN EINEM HOCHSPANNUNGSNETZ
VOLTAGE INDICATOR SYSTEM FOR HIGH-VOLTAGE NETWORK

(30) Priorité: 29.09.2017 FR 1771034
(43) Date de publication de la demande: 03.04.2019
(73) Titulaire: Schneider Electric Industries SAS, 92500 Rueil-Malmaison (FR)
(72) Inventeur: MOLLIER, Christophe, 01800 Chanoz sur Ain (FR)
(74) Mandataire: Dufresne, Thierry

(56) Documents cités:
- CN-U- 203 759 137
- DE-A1- 10 162 822
- DE-U1-202013 002 563

## Description

### Domaine technique de l'invention

La présente invention concerne un système indicateur de présence tension servant à vérifier la présence ou non de tension dans les différentes phases du réseau électrique d'une cellule d'appareillage et servant également à vérifier la concordance des phases entre deux cellules appareillage à l'aide d'un comparateur de phases. Un tel système est utilisé dans la conduite et la surveillance des réseaux électriques haute tension, c'est-à-dire de tension supérieure à 1000V.

### Etat de la technique

Dans les réseaux électriques haute tension, pour s'assurer qu'une cellule d'appareillage est hors ou sous tension, des capteurs de tension conformes à la norme CEI 61243 sont mis en place. Ces capteurs sont associés à des systèmes électroniques appelés systèmes indicateurs de présence tension, ou aussi communément VPIS («*Voltage Presence Indicating System*»), dont le fonctionnement est notamment défini dans les normes CEI 61958 et CEI 62271. Dans la suite du document, on utilisera le terme "système VPIS".

Il existe déjà des systèmes indicateurs de présence tension destinés à être raccordés à un capteur de mesure de tension pour chaque phase d'un réseau électrique, comme dans le document DE10162822A1.

Un système VPIS est directement connecté à un capteur de tension raccordé à chaque phase du réseau électrique multiphases. Le capteur de tension est préférentiellement de type capacité de traversée (également appelé capacité de "bushing"), ce qui de plus permet de pouvoir auto-alimenter le système VPIS. Un système VPIS, installé dans une cellule d'appareillage, est donc capable d'indiquer, généralement visuellement, la présence ou non d'une tension dans les différentes phases du réseau électrique de la cellule d'appareillage.

De plus, pour chaque phase, un système VPIS fournit un signal de sortie qui est notamment utilisable pour vérifier l'angle de phase de la tension réseau. On peut ainsi raccorder ce signal de sortie à un dispositif de surveillance externe, tel qu'un comparateur de phases, auquel la norme CEI 62271 s'applique également. Ainsi, pour vérifier la correspondance directe entre les phases de deux cellules d'appareillage d'un même tableau électrique, on connecte les deux systèmes VPIS des deux cellules à un comparateur de phases. Cela permet de vérifier la concordance des phases entre deux cellules, afin par exemple de vérifier le non-croisement des phases après un raccordement de ces cellules durant une reconfiguration du réseau ou après toute intervention suite à un incident. Un tel comparateur de phases est capable de détecter des écarts de phase seuls ou conjointement avec des écarts de fréquence.

Cependant, comme indiqué dans le document EP3001206, dans un système VPIS actuel, le signal de sortie destiné à un comparateur de phases fournit uniquement les seules alternances négatives de la tension mesurée sur une phase du réseau électrique. Parallèlement, un système VPIS actuel fournit également un autre signal de sortie permettant d'estimer la valeur de la tension de phase mesurée mais qui ne fournit que les seules alternances positives de la tension mesurée sur une phase du réseau électrique. Il faut donc un traitement numérique parfois complexe pour reconstituer, par des techniques d'extrapolation et de traitement du signal, la demi-alternance manquante et reformer un signal sinusoïdal complet représentatif de la tension mesurée. Or, le résultat d'un tel traitement n'est pas toujours satisfaisant et reste peu précis. Par ailleurs, un système VPIS doit rester simple et ne pas consommer trop d'énergie.

Il serait donc souhaitable qu'un système VPIS, tout en restant simple et économique, soit capable à partir d'un capteur de mesure de tension de phase d'un réseau électrique, de réaliser l'ensemble des quatre fonctions suivantes, à savoir : protection contre des surtensions, visualisation de la présence ou non de tension, délivrance d'un signal de sortie sinusoïdal représentatif de la tension mesurée et délivrance d'un autre signal de sortie sinusoïdal représentatif de l'angle de phase de la tension mesurée.

De plus, en application de la norme CEI61958 et pour des questions de sécurité, lorsqu'une des deux dernières fonctions ci-dessus est déficiente, car par exemple en court-circuit, cela ne doit pas affecter le fonctionnement des autres fonctions du système VPIS. Ainsi, si par exemple la sortie délivrant le signal représentatif de l'angle de phase de la tension mesurée est en court-circuit, il faut néanmoins que l'autre sortie délivrant le signal représentatif de la tension mesurée reste fonctionnelle, et réciproquement.

### Exposé de l'invention

Ce but est atteint par un système indicateur de présence tension qui est destiné à être raccordé à un capteur de mesure de tension pour chaque phase d'un réseau électrique haute tension et qui comporte un indicateur visuel de présence d'une tension mesurée par le capteur, un premier écrêteur ayant une première tension de régulation de façon à délivrer, sur une première borne de sortie, un premier signal de sortie sinusoïdal représentatif de la tension mesurée et un second écrêteur ayant une seconde tension de régulation de façon à délivrer, sur une seconde borne de sortie, un second signal de sortie sinusoïdal représentatif de l'angle de phase de la tension mesurée, la seconde tension de régulation étant supérieure à la première tension de régulation.

Selon une caractéristique, le système indicateur comprend pour chaque phase une première résistance de limitation reliée à la première borne de sortie, et une seconde résistance de limitation reliée à la seconde borne de sortie, la seconde résistance de limitation ayant une valeur supérieure à la première résistance de limitation.

Selon une autre caractéristique, le système indicateur comprend pour chaque phase un pont capacitif formé d'une première capacité en série avec une seconde capacité, le second écrêteur étant relié en parallèle du pont capacitif et le premier écrêteur étant relié en parallèle de la première capacité.

Selon une autre caractéristique, le système indicateur comprend pour chaque phase un dispositif de réglage d'un seuil de présence de la tension mesurée relié en parallèle avec l'indicateur visuel. Le dispositif de réglage du seuil de présence comporte un jeu de résistances commutables reliées en parallèle les unes aux autres.

Selon une autre caractéristique, le premier écrêteur et le second écrêteur sont composés de deux diodes Zener montées tête-bêche en série.

Selon une autre caractéristique, le système indicateur comprend également pour chaque phase un dispositif de protection contre les surtensions transitoires.

Selon une autre caractéristique, l'indicateur visuel comporte une LED, laquelle est alimentée de façon intermittente lorsque la tension mesurée est supérieure au seuil de présence du dispositif de réglage.

L'invention concerne également un système de comparaison de phases, comprenant un premier et un deuxième système indicateur de présence tension selon l'invention, dans lequel le comparateur de phases est relié aux secondes bornes de sortie du premier et du deuxième système indicateur de présence tension d'une même phase du réseau électrique, de façon à détecter une différence d'angle de phase entre les seconds signaux de sortie du premier et du deuxième système indicateur de présence tension

### Description détaillée

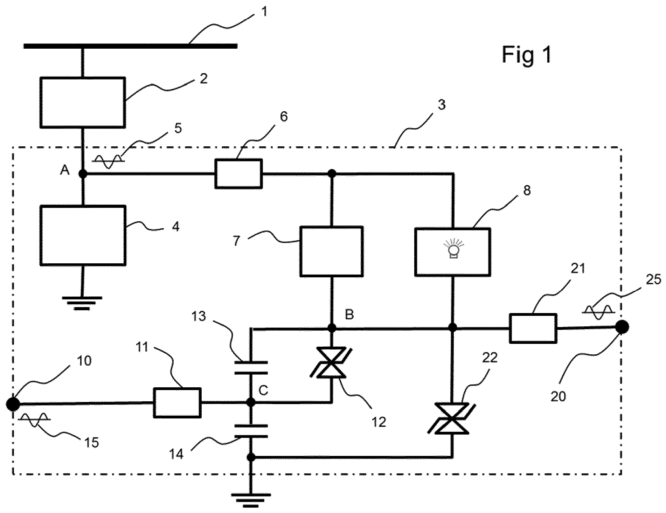

D'autres caractéristiques vont apparaître dans la description détaillée qui suit faite en regard de la figure 1 annexée qui représente le schéma de principe pour une phase d'un mode de réalisation d'un système indicateur de tension conforme à l'invention.

En référence à la figure 1, un système indicateur de présence tension, appelé aussi système VPIS, comporte un circuit électronique 3 pour chaque phase d'un réseau électrique haute tension, chaque circuit électronique 3 pouvant comporter un ou plusieurs circuits imprimés. Le circuit électronique 3 reçoit sur un point d'entrée A un signal sinusoïdal 5 provenant d'un capteur de mesure de tension 2, qui peut être une capacité de traversée. Le capteur de tension 2 est relié à une phase 1 du réseau électrique dans le but de fournir le signal 5 qui est représentatif de la tension mesurée V de la phase 1 par rapport à la terre, au niveau du point d'entrée A. Habituellement, les systèmes VPIS sont destinés à être installés en face avant d'une cellule d'appareillage haute tension.

Le système VPIS effectue d'abord une fonction de protection électrique contre les surtensions transitoires. Pour cela, le circuit électronique 3 comprend un module de protection électrique 4 qui est connecté entre le point d'entrée A et la terre. De préférence, le module 4 comprend un éclateur à gaz. L'éclateur de phase sert à la protection des biens et des personnes en cas de défaillance de la capacité de traversée 2.

Le système VPIS effectue ensuite une fonction de visualisation de la présence de la tension mesurée V par le capteur 2, ce qui permet d'indiquer facilement la présence d'une tension sur la phase 1 à un opérateur situé devant la cellule d'appareillage. Pour cela, le circuit électronique 3 comprend un indicateur visuel 8, qui est généralement composé d'une LED, et qui est relié d'un côté au point d'entrée A par l'intermédiaire d'une résistance 6 de limitation du courant d'entrée et de l'autre côté à un point milieu B du circuit électronique 3.

Cet indicateur visuel 8 s'allume lorsque la tension mesurée V dépasse un certain seuil d'allumage préconfiguré. Ce seuil d'allumage est préférentiellement réglable car les systèmes VPIS sont destinés à être installés dans des cellules d'appareillage susceptibles d'être utilisées pour des réseaux électriques haute tension de différents pays. Or les niveaux de tension varient d'un pays à l'autre (par exemple 20kV ou 15kV), certains pays ayant même plusieurs niveaux de tension distincts. Il est donc important d'assurer un seuil d'allumage réglable de l'indicateur visuel de présence tension.

C'est pourquoi, le système VPIS comporte un dispositif de réglage de seuil 7 qui est connecté en parallèle de l'indicateur visuel 8. Selon un mode de réalisation préféré, ce dispositif de réglage 7 comporte en fait une seule résistance dont la valeur est choisie en fonction du seuil d'allumage souhaité. Alternativement, le dispositif de réglage 7 pourrait être composé d'un jeu de plusieurs résistances commutables mises en parallèle, par exemple neuf résistances correspondant à neuf valeurs de seuil distinctes, ce qui permettrait de modifier plus facilement le seuil d'allumage.

Une autre variante de réalisation consisterait à utiliser un jeu de plusieurs capacités, mais le choix des résistances est guidé par la volonté d'éviter les harmoniques. Une autre variante consisterait à utiliser une association capacités/résistances.

La LED de l'indicateur visuel 8 est donc soit éteinte quand la tension mesurée est en-dessous du seuil d'allumage, soit allumée quand la tension mesurée est supérieure ou égale au seuil d'allumage. Néanmoins, pour optimiser la consommation de courant à l'intérieur du système VPIS et donc fonctionner avec un minimum de courant d'alimentation, la LED n'est pas alimentée en permanence, mais de façon intermittente seulement, en utilisant le phénomène de permanence rétinienne pour donner l'illusion d'un allumage continu.

L'indicateur visuel 8 pourra également servir en combinatoire pour aider à la vérification de la concordance de phases entre deux cellules, lorsque deux systèmes VPIS de deux cellules différentes sont utilisés en liaison avec un comparateur de phases.

Comme on le voit en figure 1, le signal 5 circule dans les différents blocs fonctionnels du système VPIS à travers la résistance 6 de limitation du courant d'entrée. Outre la limitation de courant, cette résistance 6 entre également en jeu pour la tenue CEM (compatibilité électromagnétique) aux regards des essais normatifs. Sa valeur est choisie aussi en fonction de l'éclateur 4 : plus la tension de l'éclateur 4 augmente, plus il convient d'augmenter la valeur de la résistance 6. Typiquement, une valeur de 2,7 kOhms 5% en 1/8^{ème} de Watt convient pour limiter le courant d'entrée de façon satisfaisante.

Le système VPIS fournit pour chaque phase un premier signal de sortie sinusoïdal 15 qui est représentatif de la tension mesurée V, ce qui signifie que le signal de sortie 15 permet de déterminer, moyennant un facteur d'échelle, les différents paramètres de la tension de phase mesurée, comme notamment la valeur efficace (ou valeur RMS - Root Mean Square), la valeur maximale ou crête, la forme d'onde, la fréquence fondamentale et les composantes harmoniques. Le but est de connecter au système VPIS un appareil externe qui pourra exploiter facilement et directement ce signal 15 pour différentes fonctions de qualimétrie mais aussi de calculs de puissance et d'énergie du réseau électrique. Le premier signal de sortie 15 est disponible sur une première borne de sortie 10 du circuit électronique 3 du système VPIS.

Pour cela, le circuit électronique 3 du système VPIS comporte un premier écrêteur 12 ayant une première tension de régulation. Il comporte également une première résistance de limitation 11 et un pont capacitif, lequel est formé d'une première capacité 13 en série avec une seconde capacité 14. Le point central du pont capacitif entre les capacités 13 et 14 est appelé point C. La première résistance de limitation 11 est reliée entre la première borne de sortie 10 et le point central C du pont capacitif. Le premier écrêteur 12 est relié entre le point milieu B du circuit électronique 3 et le point central C. Le pont capacitif 13, 14 est relié entre le point milieu B et la terre.

Enfin, le système VPIS fournit pour chaque phase un second signal de sortie sinusoïdal 25 qui est représentatif de l'angle de phase de la tension mesurée V. Ce second signal de sortie est disponible sur une seconde borne de sortie 20 du circuit électronique 3 de façon à pouvoir être utilisé par un appareil externe, tel qu'un comparateur de phase connecté à la borne de sortie 20. En effet, en raccordant un comparateur de phases à deux systèmes VPIS, un opérateur peut facilement contrôler la concordance des angles de phase entre deux phases et deux cellules d'appareillage distinctes, même en cas d'indisponibilité du premier signal de sortie 15.

Pour cela, le circuit électronique 3 du système VPIS comporte un second écrêteur 22 relié entre le point milieu B et la terre et ayant une seconde tension de régulation. Le circuit électronique 3 comporte également une seconde résistance de limitation 21 qui est reliée entre la seconde borne de sortie 20 et le point milieu B. La seconde tension de régulation sert à garantir un potentiel au niveau du point milieu B.

Le second signal de sortie 25 est sinusoïdal double alternance et est précis sur la phase angulaire de la tension mesurée V, ce qui le rend très facile à utiliser en liaison avec un comparateur de phases. Par contre, il n'a pas besoin d'être aussi précis que le premier signal de sortie 15 concernant les autres paramètres de la tension mesurée V.

Ainsi, dans le cas de la surveillance d'un réseau triphasé, un système VPIS comporte donc trois circuits électroniques 3 reliés trois capteurs de mesure de tension 2 et comporte trois premières bornes de sortie 10 et trois secondes bornes de sortie 20.

Préférentiellement, la valeur de la première résistance de limitation 11 est choisie comme étant la plus faible possible pour assurer le maximum de courant au signal de sortie sinusoïdal 15, lorsque celui-ci est utilisé, c'est-à-dire quand il y a une charge connectée à la première borne de sortie 10. Il faut en effet que le maximum du courant arrivant dans la résistance de limitation d'entrée 6 aille vers le premier signal de sortie 15 pour avoir le meilleur signal 15 possible.

La valeur de la seconde résistance de limitation 21 est supérieure à celle de la première résistance de limitation 11. En effet, contrairement à la première résistance de limitation 11, la valeur de la seconde résistance de limitation 21 doit être suffisamment élevée pour ne dériver qu'un minimum de courant dans le comparateur de phases. Le second signal de sortie 25 doit en effet être représentatif seulement de l'angle de phase de la tension mesurée V. Donc, il faut privilégier le passage du courant le premier signal de sortie 15 mais néanmoins s'assurer que le courant du second signal de sortie 25 soit suffisant pour alimenter un comparateur de phases qui serait connecté à la seconde borne de sortie 20.

Préférentiellement, le premier écrêteur 12 et le second écrêteur 22 sont chacun composés de deux diodes Zener montées tête-bêche en série, ce qui permet de disposer d'un signal double alternance pour les premier et second signaux de sortie 15, 25. Alternativement, des diodes Transil bidirectionnelles (ou en anglais transient-voltage-suppression diode (TVS)) pourraient aussi être utilisées.

Selon l'invention, la tension de régulation du second écrêteur 22 est supérieure à la tension de régulation du premier écrêteur 12. Cela permet de garantir que lorsque le premier signal de sortie 15 est utilisé pour des mesures, la quasi-totalité du courant traversant la résistance de limitation d'entrée 6 part bien du côté du premier signal de sortie 15. Dans le mode de réalisation choisi, la tension de régulation du second écrêteur 22 est égale à 47V alors que celle du premier écrêteur 12 est égale à 39V.

En effet, quand le premier signal de sortie 15 est utilisé, alors le premier écrêteur 12 impose sa chute de tension entre les points B et C, c'est-à-dire que la régulation des diode Zener du premier écrêteur 12 aura lieu dès 39V dans le mode de réalisation choisi. La tension au niveau du point central C du pont capacitif sera alors inférieure ou égale à la différence entre les tensions de régulation respectives des écrêteurs 12, 13. Cette tension au point C est tenue par la seconde capacité 14 du pont capacitif et simultanément par la première résistance de limitation 11 et l'impédance de l'appareil externe qui sera raccordé à la première borne de sortie 10 pour exploiter le premier signal de sortie 15.

Comme la tension de limitation du premier écrêteur 12 est inférieure à celle du second écrêteur 22, cela garantit que si le premier signal de sortie 15 est utilisé, la majorité du courant est dévié côté mesure, y compris si le second signal de sortie 25 est lui aussi utilisé (auquel cas le second écrêteur 22 viendra réguler la tension du point milieu B à 47V dans notre exemple). Donc, le courant dévié côté second signal de sortie 25 est très faible en comparaison de celui côté premier signal de sortie 15.

Typiquement, en choisissant une tension de régulation du premier écrêteur 12 de 39V, une tension de régulation du second écrêteur 22 de 47V, une valeur de 10 MOhms à 1% pour 1/8^{ème} de Watt pour la seconde résistance de limitation 21 et une valeur de 1,1 kOhms à 1% pour 1/8^{ème} de Watt pour la première résistance de limitation 11, on s'assure ainsi que la plupart du courant ira bien vers la première borne de sortie 10 tout en garantissant que le courant qui sera dévié sur la seconde borne de sortie 20 sera au maximum de 4,7µA, ce qui est un ordre de grandeur suffisant pour alimenter un comparateur de phase.

## Revendications

1. Système indicateur de présence tension destiné à être raccordé à un capteur (2) de mesure de tension pour chaque phase (1) d'un réseau électrique haute tension, **caractérisé en ce que** le système indicateur comporte pour chaque phase :
- un indicateur visuel (8) de présence d'une tension mesurée par le capteur (2),
- un premier écrêteur (12) ayant une première tension de régulation de façon à délivrer, sur une première borne de sortie (10), un premier signal de sortie (15) sinusoïdal représentatif de la tension mesurée,
- un second écrêteur (22) ayant une seconde tension de régulation de façon à délivrer, sur une seconde borne de sortie (20), un second signal de sortie sinusoïdal (25) représentatif de l'angle de phase de la tension mesurée, la seconde tension de régulation étant supérieure à la première tension de régulation.

2. Système indicateur selon la revendication 1, **caractérisé en ce qu'**il comporte pour chaque phase une première résistance de limitation (11) reliée à la première borne de sortie (10), et une seconde résistance de limitation (21) reliée à la seconde borne de sortie (20), la seconde résistance de limitation ayant une valeur supérieure à la première résistance de limitation.

3. Système indicateur selon la revendication 1, **caractérisé en ce qu'**il comporte pour chaque phase un pont capacitif formé d'une première capacité (13) en série avec une seconde capacité (14), le second écrêteur (22) étant relié en parallèle du pont capacitif et le premier écrêteur (12) étant relié en parallèle de la première capacité (13).

4. Système indicateur selon la revendication 1, **caractérisé en ce qu'**il comporte pour chaque phase un dispositif de réglage (7) d'un seuil de présence de la tension mesurée relié en parallèle avec l'indicateur visuel (8).

5. Système indicateur selon la revendication 4, **caractérisé en ce que** le dispositif de réglage (7) du seuil de présence comporte un jeu de résistances commutables reliées en parallèle les unes aux autres.

6. Système indicateur selon la revendication 1, **caractérisé en ce que** le premier écrêteur (12) et le second écrêteur (22) sont composés de deux diodes Zener montées tête-bêche en série.

7. Système indicateur selon la revendication 1, **caractérisé en ce qu'**il comporte également pour chaque phase un dispositif de protection (4) contre les surtensions transitoires.

8. Système indicateur selon la revendication 1, **caractérisé en ce que** l'indicateur visuel (8) comporte une LED, laquelle est alimentée de façon intermittente seulement lorsque la tension mesurée est supérieure au seuil de présence du dispositif de réglage (7).

9. Système de comparaison de phases, comprenant un premier et un deuxième système indicateur de présence tension selon l'une des revendications précédentes et un comparateur de phases, dans lequel le comparateur de phases est relié aux secondes bornes de sortie (20) du premier et du deuxième système indicateur de présence tension d'une même phase (1) du réseau électrique, de façon à détecter une différence d'angle de phase entre les seconds signaux de sortie (25) du premier et du deuxième système indicateur de présence tension.

## Patentansprüche

1. System zur Anzeige des Vorhandenseins einer Spannung, das für jede Phase (1) eines elektrischen Hochspannungsnetzes mit einem Sensor (2) zur Spannungsmessung verbunden werden soll, **dadurch gekennzeichnet, dass** das Anzeigesystem für jede Phase Folgendes aufweist:
- eine optische Anzeige (8) des Vorhandenseins einer vom Sensor (2) gemessenen Spannung,
- einen ersten Begrenzer (12) mit einer ersten Regelspannung, um an einer ersten Ausgangsklemme (10) ein erstes sinusförmiges Ausgangssignal (15) auszugeben, das repräsentativ für die gemessene Spannung ist,
- einen zweiten Begrenzer (22) mit einer zweiten Regelspannung, um an einer zweiten Ausgangsklemme (20) ein zweites sinusförmiges Ausgangssignal (25) auszugeben, das repräsentativ für den Phasenwinkel der gemessenen Spannung ist, wobei die zweite Regelspannung größer ist als die erste Regelspannung.

2. Anzeigesystem nach Anspruch 1, **dadurch gekennzeichnet, dass** es für jede Phase einen ersten Begrenzungswiderstand (11) aufweist, der mit der ersten Ausgangsklemme (10) verbunden ist, und einen zweiten Begrenzungswiderstand (21), der mit der zweiten Ausgangsklemme (20) verbunden ist, wobei der zweite Begrenzungswiderstand einen Wert aufweist, der größer als der erste Begrenzungswiderstand ist.

3. Anzeigesystem nach Anspruch 1, **dadurch gekennzeichnet, dass** es für jede Phase eine kapazitive Brücke aufweist, die aus einem ersten Kondensator (13) in Reihe mit einem zweiten Kondensator (14) gebildet wird, wobei der zweite Begrenzer (22) parallel zu der kapazitiven Brücke geschaltet ist und der erste Begrenzer (12) parallel zum ersten Kondensator (13) geschaltet ist.

4. Anzeigesystem nach Anspruch 1, **dadurch gekennzeichnet, dass** es für jede Phase eine Einstellvorrichtung (7) für eine Schwelle des Vorhandenseins der gemessenen Spannung aufweist, die parallel zu der optischen Anzeige (8) geschaltet ist.

5. Anzeigesystem nach Anspruch 4, **dadurch gekennzeichnet, dass** die Einstellvorrichtung (7) für eine Schwelle des Vorhandenseins einen Satz von schaltbaren Widerständen aufweist, die parallel zueinander geschaltet sind.

6. Anzeigesystem nach Anspruch 1, **dadurch gekennzeichnet, dass** der erste Begrenzer (12) und der zweite Begrenzer (22) aus zwei Zenerdioden bestehen, die entgegengesetzt in Reihe geschaltet sind.

7. Anzeigesystem nach Anspruch 1, **dadurch gekennzeichnet, dass** es außerdem für jede Phase eine Schutzvorrichtung (4) gegen transiente Überspannungen aufweist.

8. Anzeigesystem nach Anspruch 1, **dadurch gekennzeichnet, dass** die optische Anzeige (8) eine LED aufweist, die nur dann intermittierend gespeist wird, wenn die gemessene Spannung größer als die Schwelle des Vorhandenseins der Einstellvorrichtung (7) ist.

9. Phasenvergleichssystem, das ein erstes und ein zweites System zur Anzeige des Vorhandenseins einer Spannung nach einem der vorhergehenden Ansprüche und einen Phasenkomparator aufweist, wobei der Phasenkomparator mit den zweiten Ausgangsklemmen (20) des ersten und des zweiten Systems zur Anzeige des Vorhandenseins einer Spannung derselben Phase (1) des elektrischen Netzes verbunden ist, um eine Phasenwinkeldifferenz zwischen den zweiten Ausgangssignalen (25) des ersten und des zweiten System zur Anzeige des Vorhandenseins einer Spannung zu erfassen.

## Claims

1. Voltage presence indicating system intended to be connected to a voltage measurement sensor (2) for each phase (1) of a high-voltage electrical network, **characterized in that** the indicating system includes for each phase:
- a visual indicator (8) of the presence of a voltage measured by the sensor (2),
- a first peak limiter (12) having a first regulation voltage so as to deliver, at a first output terminal (10), a first sinusoidal output signal (15) representing the measured voltage,
- a second peak limiter (22) having a second regulation voltage so as to deliver, at a second output terminal (20), a second sinusoidal output signal (25) representing the phase angle of the measured voltage, the second regulation voltage being greater than the first regulation voltage.

2. Indicating system according to Claim 1, **characterized in that** it includes for each phase a first limiter resistor (11) connected to the first output terminal (10), and a second limiter resistor (21) connected to the second output terminal (20), the second limiter resistor having a higher value than the first limiter resistor.

3. Indicating system according to Claim 1, **characterized in that** it includes for each phase a capacitive bridge formed of a first capacitor (13) in series with a second capacitor (14), the second peak limiter (22) being connected in parallel with the capacitive bridge and the first peak limiter (12) being connected in parallel with the first capacitor (13).

4. Indicating system according to Claim 1, **characterized in that** it includes for each phase a device (7) for adjusting a presence threshold for the measured voltage connected in parallel with the visual indicator (8).

5. Indicating system according to Claim 4, **characterized in that** the adjuster device (7) includes a set of switchable resistors connected in parallel with one another.

6. Indicating system according to Claim 1, **characterized in that** the first peak limiter (12) and the second peak limiter (22) consist of two Zener diodes connected in opposite directions in series.

7. Indicating system according to Claim 1, **characterized in that** it also includes for each phase a device (4) for protection against transient voltage surges.

8. Indicating system according to Claim 1, **characterized in that** the visual indicator ((8) includes an LED that is powered intermittently only when the measured voltage is greater than the presence threshold of the adjuster device (7).

9. Phase comparison system, comprising first and second voltage presence indicating systems according to any one of the preceding claims and a phase comparator, in which the phase comparator is connected to the second output terminals (20) of the first and second voltage presence indicating systems of the same phase (1) of the electrical network, so as to detect a phase angle difference between the second output signals (25) of the first and second voltage presence indicating systems.
